# EUROPEAN PATENT APPLICATION

(11) **EP 2 249 403 A1**
(43) Date of publication of application: **10.11.2010**
(21) Application number: 08757355.6
(22) Date of filing: 27.05.2008
(51) Int. Cl.: H01L 33/00

(54) **A MANUFACTURING METHOD OF LED APPARATUS**

(30) Priority: 25.02.2008 CN 200810026479
(71) Applicant: He Shan Lide Electronic Enterprise Company Ltd, He Shan, Guandong 529728 (CN)
(72) Inventor: FAN, Ben, He Shan Guangdong 529728 (CN); WENG, Joe, He Shan Guangdong 529728 (CN)
(74) Representative: Becker Kurig Straus
(86) International application number: PCT/CN2008/001024
(87) International publication number: WO 2009/105923

(57) **Abstract**

A manufacturing method of LED apparatus, luminous surface of the LED and boding wire area (13,39) are comparted by compartmentation baffle (12,27,38), thereby phosphor is only coated the luminous surface within the process of coating phosphor. The method also can be applied to flip chip structure or perpendicularity of the LED apparatus. The method can manufacture white light LED directly and has no need of packaging process of adopting phosphor within packaging process, thereby the method predigests the manufacturing process of the white light LED.

## Description

### BACKGROUND OF THE INVENTION

### 1. Field of the Invention

The present invention relates to manufacturing method of an LED apparatus, especially to a method of manufacturing an LED apparatus that comparts a luminous surface from other regions of the semi-manufactured LED apparatus, such as a bonding wire area, for coating phosphors only on the luminous surface.

### 2. Description of the Related Art

Light-emitting diodes (LED) are forward-biased P-N junction diodes made of semiconductor materials. When terminals of the PN junction diodes are biased in a forward direction, the recombination of non-equilibrium carriers (electron-hole pairs) causes an emission of light. Foregoing light-emitting process primarily corresponds to a spontaneous light-emitting process. Materials for manufacturing the LED are heavily doped and therefore form a PN junction wherein an n-type region has an excess of free electrons and a p-type region with an excess of holes under a thermal equilibrium condition. A depletion region forms spontaneously across a P-N junction and prevents electrons and holes from recombining. When the p-n junction is forward-biased with a sufficient voltage, the depletion region will be narrowed and electrons can overcome a resistivity of the depletion region to cross the PN junction and inject into a side of the PN junction near the p-type region. Electrons then meet and recombine with holes and the recombination thereby results in light emission.

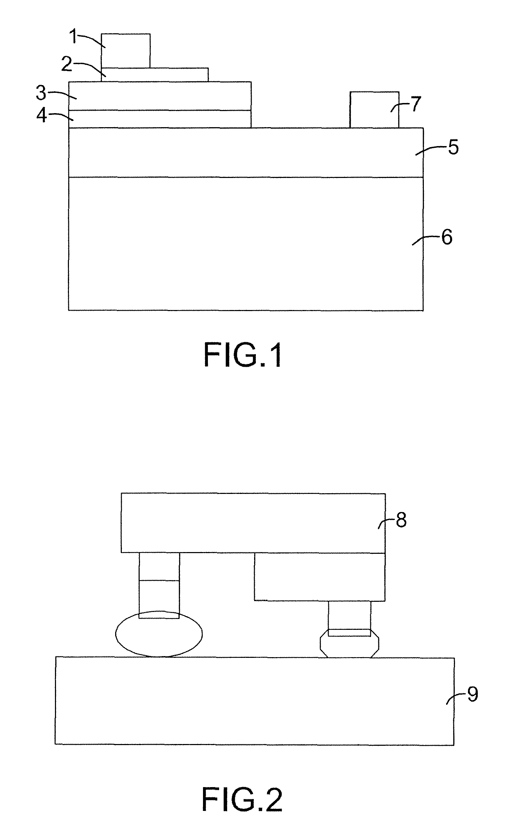

Generally, a conventional light-emitting diode (LED) is manufactured by forming a laminated structure mounted on a substrate wherein the laminated structure comprises an n-type semiconductor material layer, a luminous layer and a p-type semiconductor material layer. The conventional LED may adopt different materials and structures to meet different desired wavelengths of emitted lights. For example, blue and green LEDs usually use sapphire as a substrate and GaInN epitaxial structure as a laminated structure. Because the sapphire is used as the substrate, an anode and a cathode of the conventional light-emitting diode are formed at the same side of the substrate. As reference to Fig. 1, an n-type GaN layer 5, a luminous layer 4, a p-type GaN layer 3 and a transparent electrode layer 2 are sequentially formed on a sapphire substrate 6. An anode 1 and a cathode 7 are respectively formed on the transparent electrode layer 2 and the n-type GaN layer 5. However, the sapphire substrate 6 is weak at heat dissipating and a heat-conductive structure is disposed at a distance from the luminous layer 4. Therefore the conventional LEDs are limited to be manufactured into small-area ones with low power, such as one LED having an area of 0.3mmx0.3mm with an operating current at 20mA.

With the requirements of a higher lighting efficiency and better illumination, a conventional LED apparatus having a flip chip structure gradually replaces foregoing conventional LED apparatus as a high power LED apparatus. With reference to Fig. 2, a back side of a flip-chip 8 functions as a luminous surface, and electrodes at a front side of the flip-chip 8 is attached to a heat-sink side of a silicon substrate 9 wherein the silicon substrate 9 functions as a heat-conductive structure. Since the flip-chip 8 are close to the silicon substrate 9, a heat-dissipating efficiency is enhanced. Therefore, area of an LED apparatus can be increased to 1mm x 1mm, operating current can be achieved to 300 or 500 mA and then the LED apparatus can be provided with a power up to 1 Watt.

High power LED apparatuses are mainly applied to white light illumination. A technique of manufacturing white LED apparatuses usually requires a package technique of packaging phosphors. However, during a process of manufacturing white LED apparatuses, phosphor coating is hard to control and uneven white light illumination may occur to influence color temperature and coordinate of emitted white lights, and thereby lead to a package yield decrease. Such package defect is particularly obvious to a high power white LED apparatus.

### SUMMARY OF THE INVENTION

According to the present invention, a manufacturing method of LED apparatus is provided. The method in accordance with the present invention utilizes compartmentation baffle to compart the luminous surface of an LED from the other regions, such as a bonding wire area by compartmentation baffles on the bonding wire area and coating phosphors only on the luminous surface of the LED within a process of coating phosphor. Thus, a packaging process of adopting phosphor within packaging process can be omitted.

Preferably, the LED apparatus is a high-power white LED apparatus.

Preferably, the LED apparatus has a flip-chip structure or a vertical chip structure.

According to the present invention, a method of manufacturing LED apparatus having a flip-chip structure is provided. The method in accordance with the present invention comprises steps of mounting at least one flip-chip structure on a top of a base, disposing a compartmentation baffle on a bonding wire area to compart a back surface of the transparent electrode layer being as a luminous surface of the flip chip structure from the bonding wire area, wherein the bonding wire area is disposed on the top of the base and surrounding the at least one flip-chip structure, coating a slurry of phosphors on the transparent electrode layer, evaporating solvents of the slurry by heating to solidify the phosphors and thereby form a phosphor layer, removing the compartmentation baffle and cutting the base into sections to form at least one single-unit LED apparatuses having a flip-chip structure.

According to the present invention, a method of manufacturing LED apparatus having a vertical chip structure is provided. The method in accordance with the present invention comprises steps of mounting at least one vertical chip structure on a top of a base, wherein each of the at least one vertical chip structure comprises a p side electrode, a p-type semiconductor material layer, a luminous layer, a n-type semiconductor material layer and a transparent electrode layer being sequentially disposed on the base, the transparent electrode layer functions as a luminous surface and a bonding wire area is disposed on a part of the transparent electrode layer, disposing a compartmentation baffle on the bonding wire area to compart the bonding wire area from the rest of the transparent electrode layer, coating a slurry of phosphors on the transparent electrode layer, evaporating solvents of the slurry by heating to solidify the phosphors to form a phosphor layer, removing the compartmentation baffle and cutting the base into sections to form at least one single-unit LED apparatus having a vertical chip structure.

According to the present invention, a method of manufacturing LED apparatus having a flip chip structure is provided. The method in accordance with the present invention comprises steps of mounting at least one flip chip structure on a top of a base, wherein a metal joint layer is disposed between the at least one flip-chip structure and the top of the base, and a periphery part of the metal joint layer surrounds the at least one flip-chip structure, disposing a compartmentation baffle on the periphery part of the metal joint layer to compart a n-type semiconductor material layer being opposite to the metal joint layer from the periphery part of the metal joint layer, coating a slurry of phosphors on the n-type semiconductor material layer, evaporating solvents of the slurry by heating to solidify the phosphors and thereby form a phosphor layer, removing the compartmentation baffle and cutting the base into sections to form at least one single-unit LED apparatus having a flip-chip structure.

Preferably, a roughened layer having a rough surface is disposed between the phosphor layer and the flip or vertical chip structure to enhance adhesion of phosphors on the luminous surface.

Accordingly, the white LED apparatus can be directly manufactured without using a phosphor package technique, and thereby the whole manufacturing process of white LED apparatus is simplified.

### BRIEF DESCRIPTION OF THE DRAWINGS

Fig. 1 is a side view of a conventional blue and green light-emitting diode in accordance with the prior art;
Fig. 2 is a side view of a conventional LED apparatus adopting a flip-chip structure in accordance with the prior art;
Fig. 3 is a plane view of a compartmentation baffle that is used when applying a method in accordance with the present invention to manufacture an LED apparatus having a flip chip structure;
Fig. 4 is a side view of manufacturing the LED apparatus having a flip chip structure with the compartmentation baffle shown in Fig. 3;
Fig. 5 is a plane view of a compartmentation baffle that is used when applying another method in accordance with the present invention to manufacture an LED apparatus having another flip chip structure;
Fig. 6 is a side view of manufacturing the LED apparatus having the another flip chip structure with the compartmentation baffle shown in Fig. 5;
Fig. 7 is a plane view of a compartmentation baffle that is used when applying the method in accordance with the present invention to manufacture an LED apparatus having a vertical chip structure; and
Fig. 8 is a side view of manufacturing the LED apparatus having a vertical chip structure with the compartmentation baffle shown in Fig. 7.

### DETAILED DESCRIPTION OF THE PREFERRED EMBODIMENTS

It can be further explained with the help of the appending drawings and implementing illustration.

According to the present invention, using a compartmentation baffle to compart a luminous surface of an LED apparatus from other regions like a bonding wire area and coating phosphors only on the luminous surface during a process of coating phosphor can improve uniformity of the phosphor coating and omit a phosphor package technique of a package process. The present invention can be applied in manufacturing LED apparatus having a flip chip structure or a vertical chip structure.

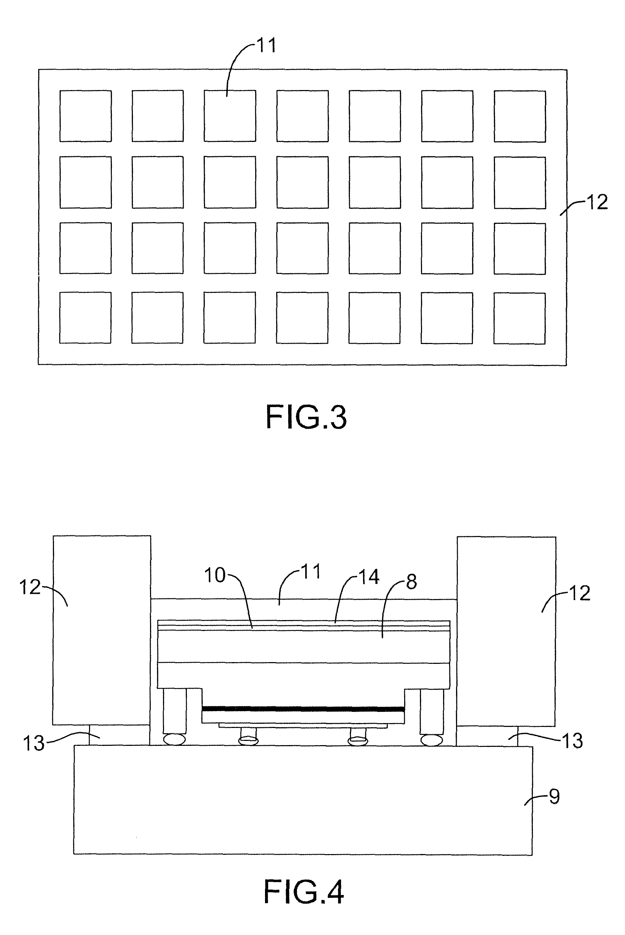

Fig. 3 is a plane view of a compartmentation baffle that is used when applying a method in accordance with the present invention to manufacture an LED apparatus having a flip chip structure. Fig. 4 is a side view of manufacturing the LED apparatus having a flip chip structure with the compartmentation baffle shown in Fig. 3. With reference to Fig. 4, at least one flip chip structure having a transparent substrate 8 that may be made of sapphire is mounted on a top of a base 9 with a topside of the at least one flip chip structure facing the base 9. The base 9 may be composed of materials selected from the group consisting of silicon, aluminum nitride, copper, gallium nitride, zinc oxide and combinations. A transparent electrode layer 10 functioning as a luminous surface of the at least one flip chip structure is disposed on a back surface of the transparent substrate 8. A roughened layer 14 having a rough surface may be selectively disposed on the transparent electrode layer 10 to enhance adhesion of phosphors when coating the phosphors to the at least one flip chip structure. Alternatively, the roughened layer 14 can be omitted. A bonding wire area 13 surrounds the flip chip structure. A compartmentation baffle 12 is disposed on the bonding wire area 13 to compart the transparent electrode layer 10 functioning as a luminous surface from the bonding wire area. Fig. 3 shows a plane view of a compartmentation baffle being applied in multiple flip chip structures. The compartmentation baffle has multiple openings having gauges corresponding to sizes of the flip chip structures. Slurry of phosphors is directly coated on the transparent electrode layer 10 and may be on the roughened layer 14 by spin coating or instillation coating. Evaporating solvents of the slurry by heating solidifies the phosphors and thereby forms a phosphor layer 11. After forming the phosphor layer 11, the compartmentation baffle 12 will be removed. Through foregoing step, the phosphors can be evenly coated and solidified on the luminous surface of the flip chip structure. Therefore adopting a phosphor package technique during a package process can be avoided. Then, the base 9 will be cut into sections to form a single-unit LED apparatus having a flip chip structure.

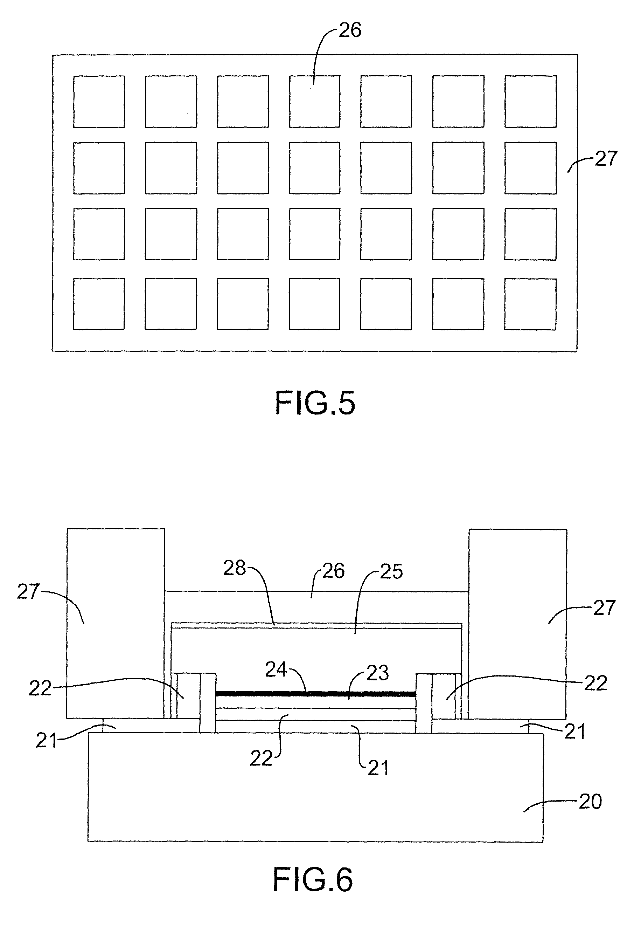

Fig. 5 is a plane view of a compartmentation baffle that is used when applying a method in accordance with the present invention to manufacture an LED apparatus having another flip chip structure. Fig. 6 is a side view of manufacturing the LED apparatus having the another flip chip structure with the compartmentation baffle shown in Fig. 5. With reference to Fig. 6, at least one flip chip structure is mounted on a top of a base 20 through a metal joint layer 21. The base 20 may be composed of materials selected from the group consisting of silicon, aluminum nitride, copper, gallium nitride, zinc oxide and combinations. The at least one flip chip structure comprises a reflective metal layer 22 being opposite to the metal joint layer 21 and a light-emitting laminated structure. The light-emitting structure comprises a p-type semiconductor material layer 23, a quantum-well emission layer 24 and an n-type semiconductor material layer 25 being sequentially disposed on the reflective metal layer 22. The flip chip structure in Fig. 6 differs from the flip chip structure in Fig. 4 by having the transparent sapphire substrate removed. A roughened layer 28 having a rough surface may be selectively disposed on the n-type semiconductor material layer 25 to enhance adhesion of phosphors when coating the phosphors to the at least one flip chip structure. Alternatively, the roughened layer 28 can be omitted. A compartmentation baffle 27 is disposed on the periphery part of the metal joint layer 21 to compart the n-type semiconductor material layer 25 functioning as a luminous surface from the periphery part of the metal joint layer 21. The compartmentation baffle 27 has multiple openings having gauges corresponding to plane sizes of the n-type semiconductor material layer 25. Slurry of phosphors is directly coating on the roughened layer 28 by spin coating or instillation coating. Evaporating solvents of the slurry by heating solidifies the phosphors and thereby forms a phosphor layer 26. After forming the phosphor layer 26, the compartmentation baffle 27 will be removed and then the base 20 will be cut into sections to form a single-unit LED apparatus having a flip chip structure. Through foregoing step, the phosphors can be evenly coated and solidified on the luminous surface of the flip chip structure. Therefore adopting a phosphor package technique during a package process can be avoided.

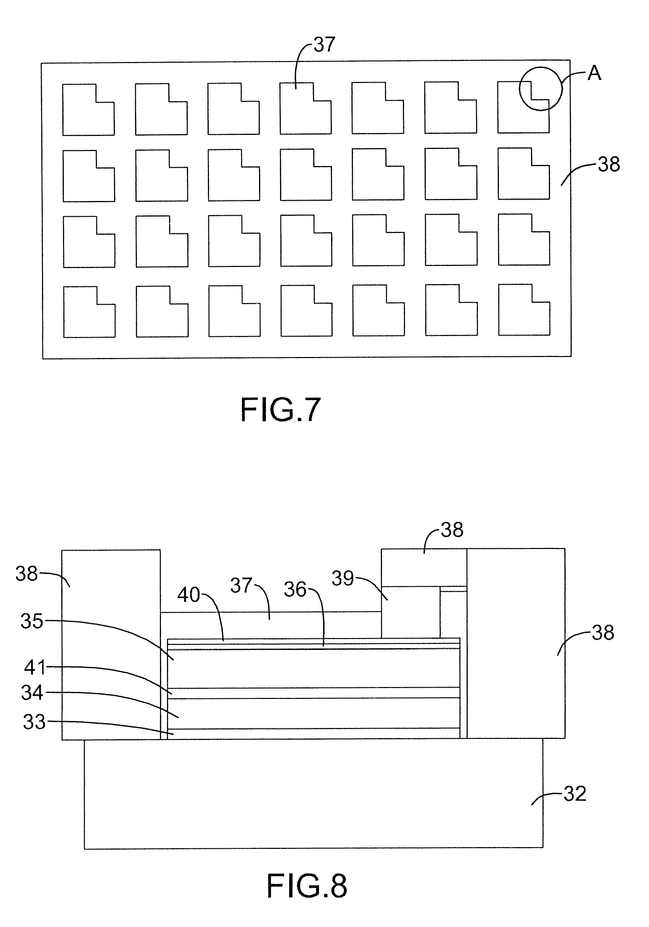

Fig. 7 is a plane view of a compartmentation baffle that is used when applying a method in accordance with the present invention to manufacture an LED apparatus having a vertical chip structure. Fig. 8 is a side view of manufacturing the LED apparatus having a vertical chip structure with the compartmentation baffle shown in Fig. 7. With reference to Fig. 8, the vertical chip structure comprises a p side electrode 33, a p-type semiconductor material layer 34, a luminous layer 41, a n-type semiconductor material layer 35 and a transparent electrode layer 36 being disposed on a base 32 in sequence. The transparent electrode layer 36 functions as a luminous surface of the vertical structure. A roughened layer 40 having a rough surface may be selectively disposed on the transparent electrode layer 36 to enhance adhesion of phosphors when coating the phosphors to the vertical chip structure. Alternatively, the roughened layer 40 can be omitted. A bonding wire area 39 is disposed on a part of the rough surface of the roughened layer 40. Fig. 7 shows a plane view of a compartmentation baffle 38 being applied in multiple vertical chip structures mounted on the base 32. The compartmentation baffle 38 differs from the compartmentation baffle 12, 27 by having extensions A for respectively comparting each bonding wire area 39. The compartmentation baffle 38 has multiple openings corresponding in shape and in size to the luminous surface of each flip chip structure. Then, slurry of phosphors is directly coating on the luminous surface by spin coating or instillation coating. Evaporating solvents of the slurry by heating solidifies the phosphors and thereby forms a phosphor layer 37. After forming the phosphor layer 37, the compartmentation baffle 38 will be removed. Through foregoing step, the phosphors can be evenly coated and solidified on the luminous surface of the vertical chip structure. Therefore adopting a phosphor package technique during a package process can be avoided. Then, the base 32 will be cut to form a single-unit LED apparatus having a vertical chip structure.

The present invention can also be applied in other LED apparatus having other kind of chip structure, especially can be applied in high power LED apparatus having a phosphor layer.

According to the present invention, using a compartmentation baffle to compart a luminous surface of an LED apparatus from other regions like a bonding wire area and thereby coating phosphors alone on the luminous surface during a process of coating phosphor can improve uniformity of the phosphors. For a white LED apparatus, uniformity of color temperature and coordinate of white lights can be effectively controlled. Therefore, the white LED apparatuses can be directly manufactured without adopting a phosphor package technique, and thereby a package process of the white LED apparatus is simplified.

## Claims

1. A method of manufacturing an LED appartus comprising steps of comparting an luminous surface of an LED chip from a bonding wire area by compartmentation baffles on the bonding wire area and coating phosphors on the luminous surface of the LED chip during a process of coating phosphor.

2. The method as claimed in claim 1, wherein the LED apparatus is a high-power white LED apparatus.

3. The method as claimed in claim 1 or 2, wherein the LED apparatus has a flip-chip structure or a vertical structure.

4. A method of manufacturing an LED apparatus having a flip-chip structure comprising steps of:
mounting at least one flip-chip structure on a top of a base (9), each of the at least one flip chip structure comprising a transparent substrate (8) and a transparent electrode layer 10 being mounted on the back surface of the transparent substrate (8) and being as a luminous surface of the flip chip structure, a bonding wire area (13) disposed on the top of the base (8) and surrounding the at least one flip-chip structure,
coating a slurry of phosphors on the transparent electrode layer (10);
evaporating solvents of the slurry by heating to solidify the phosphors and thereby form a phosphor layer (11);
removing a compartmentation baffle (12); and
cutting the base (9) into sections to form a single-unit LED apparatuses having a flip-chip structure.

5. The method as claimed in claim 4, wherein a roughened layer (14) having a rough surface is disposed between the transparent electrode layer (10) and the phosphor layer (11).

6. The method as claimed in claim 4 or 5, wherein the LED apparatus is a high-power white LED apparatus.

7. A method of manufacturing an LED apparatus having a flip-chip structure comprising steps of:
mounting at least one flip chip structure on a top of a base (20), wherein a metal joint layer (21) is disposed between the at least one flip-chip structure and the top of the base (20), each of the at least one flip-chip structure comprises a reflective metal layer (22) being opposite to the metal joint layer (21) and a n-type semiconductor material layer (25) being as a luminous surface and a periphery part of the metal joint layer surrounds the at least one flip-chip structure;
disposing a compartmentation baffle (27) on the periphery part of the metal joint layer (21) to compart the n-type semiconductor material layer (25) from the periphery part of the metal joint layer (21);
coating a slurry of phosphors directly on the n-type semiconductor material layer (25);
evaporating solvents of the slurry by heating to solidify the phosphors and thereby form a phosphor layer (26);
removing the compartmentation baffle (27); and
cutting the base (20) to form a single-unit LED apparatus having a flip-chip structure.

8. The method as claimed in claim 7, wherein a roughened layer (28) having a rough surface is disposed between the n-type semiconductor material layer (25) and the phosphor layer (26).

9. The method as claimed in claim 7 or 8, wherein the LED apparatus is a high-power white LED apparatus.

10. A method of manufacturing an LED apparatus having a vertical chip structure comprising steps of:
mounting at least one vertical chip structure on a top of a base (32) and each of the at least one vertical chip structure comprising a n side electrode (33), a n-type semiconductor material layer (34) , a luminous layer (41), a p-type semiconductor material layer (35) and a transparent electrode layer (36) being sequentially disposed, wherein the transparent electrode layer (36) functions as a luminous surface of the vertical chip structure and a bonding wire area (39) is disposed on a part of the transparent electrode layer (36);
disposing a compartmentation baffle (38) on the bonding wire area (39) to compart the bonding wire area (39) from the rest of the transparent electrode layer (36);
coating a slurry of phosphors directly on the transparent electrode layer (36);
evaporating solvents of the slurry by heating to solidify the phosphors to form a phosphor layer (37);
removing the compartmentation baffle (38); and
cutting the base (32) to form a single-unit LED apparatus having a vertical chip structure.

11. The method as claimed in claim 10, wherein a roughened layer (40) having a rough surface is disposed between the transparent electrode layer (36) and the phosphor layer (37).

12. The method as claimed in claim 10 or 11, wherein the LED apparatus is a high-power white LED apparatus.
